# EUROPEAN PATENT APPLICATION

(11) **EP 4 333 270 A1**
(43) Date of publication of application: **06.03.2024**
(21) Application number: 22193788.1
(22) Date of filing: 02.09.2022
(51) Int. Cl.: H02K 7/116, H02K 11/33, H05K 7/20, F16H 57/02, F16H 57/04

(54) **INVERTER ASSEMBLY FOR AN ELECTRIC MOTOR OR FOR A GEARBOX**

(71) Applicant: Valeo eAutomotive Germany GmbH, 91056 Erlangen (DE)
(72) Inventor: Eichner, Markus, 91056 C/o VEA, Erlangen (DE); Fürstenhöfer, Christian, 91056 C/o VeA, Erlangen (DE); Pfeiffer, Kay, 91056 C/o VEA, Erlangen (DE)
(74) Representative: Valeo Powertrain Systems

(57) **Abstract**

Inverter assembly (10) for an electric motor (4) or for a gearbox, comprising a support structure, power electronics (15), a cooling channel (14), a DC-link capacitor (12) and a printed circuit board (PCB) (16), wherein the inverter assembly (10) is configured as a pre-assembled component, which is attachable to the electric motor (4) or to the gearbox. In addition, an electric motor or a gearbox assembly (1) and a method for assembling an electric motor (1) or a gearbox assembly are proposed.

## Description

The invention refers to an inverter assembly for an electric motor or for a gearbox, said inverter assembly comprising a support structure, power electronics, a cooling channel, a DC-link capacitor and a printed circuit board (PCB).

Electric machines are increasingly being used in electrically powered vehicles and hybrid vehicles, predominantly as an electric motor for driving a wheel or an axle of a vehicle.

Such an electric motor is usually mechanically coupled to a gearbox for speed adjustment. In addition, the electric motor is usually electrically coupled with an inverter assembly which generates an alternating voltage for operating the electric motor from a direct voltage supplied by a battery.

Conventionally, the inverter assembly is often integrated in a motor housing, which may also comprise a gearbox. However, as the gearbox is partly filled with oil, there may be issues with technical cleanliness. Further, the electric motor and the gearbox are both comparatively heavy, so that handling and testing of the arrangement, comprising the electric motor, the gearbox and the inverter assembly is difficult. Accordingly, the invention is based on the problem to provide an inverter assembly, which can be handled and tested easier.

This problem is solved by an inverter assembly with the features of claim 1. According to the invention, the inverter assembly is configured as a pre-assembled component, which is attachable to an electric motor.

According to the invention, the inverter assembly is configured as a pre-assembled component, which is attachable to a gearbox.

The invention is based on the idea that the inverter assembly, after it has been manufactured, can be tested separately from the electric motor or from the gearbox, before it has been attached respectively to the electric motor or to the gearbox. In addition, the inverter assembly is better protected against oil or other debris from the electric motor and/or from the gearbox, when it is a pre-assembled component, which is a separate module.

According to a preferred embodiment, the support structure can be a carrier plate. All components of the inventive inverter assembly, namely the DC link capacitor, the power electronics, an AC-busbar and the PCB can be arranged directly or indirectly on the carrier plate.

In the inventive inverter assembly it is particularly preferred that the cooling channel is integrated in the support structure. The cooling channel can be part of a cooling circuit with an inlet and an outlet, which are connected to the integrated cooling channel. A cooling fluid can be pumped in a circuit through the cooling channel in order to dissipate heat from the inverter assembly, in particular from the power electronics.

Preferably, one side of the power electronics is disposed on the PCB and the opposite side is directly attached to the cooling channel, in order to dissipate heat from the power electronics efficiently.

A main advantage of the inventive inverter assembly is that it is configured without an inverter housing. As no inverter assembly is necessary, the mass of the inverter assembly can be reduced, in addition the manufacturing costs are lower as well. According to a preferred embodiment, the cooling channel is connectable or connected to a cooling channel of the electric motor or to a cooling channel of the gearbox. In this case no separate cooling circuit requiring an own pump is necessary.

The invention is further related to an electric motor assembly, comprising an electric motor, the inverter assembly, a motor housing with a cavity for the electric motor, wherein the motor housing comprises a separate inverter compartment, in which the inverter assembly is received.

Providing a separate inverter compartment has the advantage that the inverter assembly does not require a separate housing. The separate inverter compartment protects the inverter against contamination from the inside of the electric motor or from the inside of the gearbox.

Preferably, the cavity for the electric motor and the inverter compartment are separated by a wall of the motor housing. The inverter assembly is therefore arranged at the outer side of the motor housing, separately from the electric motor itself. Preferably, the inverter compartment is a closed compartment, which protects all sides of the inverter assembly.

In the inventive electric motor assembly it is preferred that the inverter compartment comprises a mounting dome with struts, on which the inverter assembly is arranged. The inverter assembly, in particular its carrier plate, can be attached to struts of the mounting dome. The struts can therefore be equipped with threaded bores, so that the inverter assembly can be fixed with screws.

The electric motor assembly may comprise a cover which closes an opening of the inverter compartment. By detaching the cover of the inverter compartment the inverter assembly is accessible, so that the inverter assembly can be tested, removed or replaced, if necessary.

The invention is further related to a gearbox assembly, comprising a gearbox, the inverter assembly, a gearbox housing with a cavity for the gearbox, wherein the gearbox housing comprises a separate inverter compartment, in which the inverter assembly is received.

Preferably, the cavity for the gearbox and the inverter compartment are separated by a wall of the gearbox housing. The inverter assembly is therefore arranged at the outer side of the gearbox housing, separately from the gearbox itself. Preferably, the inverter compartment is a closed compartment, which protects all sides of the inverter assembly.

Preferably, the inverter compartment comprises a mounting dome with struts, on which the inverter assembly is arranged.

Preferably, the inverter compartment is provided with a cover, which closes an opening of the inverter compartment.

The invention is further related to a method for assembling an electric motor assembly, comprising the following steps: placing an electric motor in a motor housing; pre-assembling an inventive inverter assembly, comprising a support structure, power electronics, a cooling channel, a DC-link capacitor and a printed circuit board (PCB); and arranging the inverter assembly in a separate inverter compartment of a motor housing.

The invention is further related to a method for assembling a gearbox assembly, comprising the following steps: placing a gearbox in a gearbox housing; pre-assembling an inventive inverter assembly, comprising a support structure, power electronics, a cooling channel, a DC-link capacitor and a printed circuit board (PCB); and arranging the inverter assembly in a separate inverter compartment of a gearbox housing.

The invention is explained by means of a preferred example with reference to the drawing.

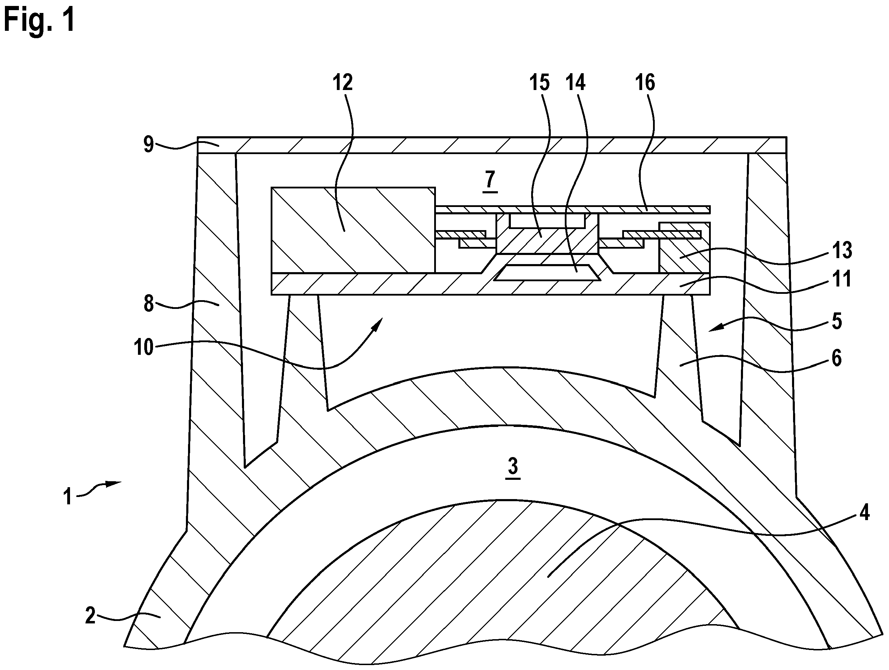

Fig. 1 is a schematic representation and shows a detail of an embodiment of an inventive electric motor assembly comprising an inventive inverter assembly in a sectional view.

In Fig.1 it is represented an electric motor assembly but it could be also a gearbox assembly instead.

The electric motor assembly 1 comprises a motor housing 2 with a cavity 3, in which an electric motor 4 is received. In the case it will be a gearbox assembly, it is to be noted that it will comprise a gearbox housing (not illustrated) with a gearbox cavity (not illustrated) in which a gearbox will be received.

On top of the motor housing 2 a mounting dome 5 with struts 6 is arranged. An inverter compartment 7 is defined by walls 8, which surround the mounting dome 5 and a cover 9, which closes an opening of the inverter compartment 7. In the figure it is visible that the inverter compartment 7 is completely secluded from the cavity 3 inside the motor housing 2, so that motor oil or cooling fluid from the electric motor 4 cannot enter the inverter compartment 7.

In the inverter compartment 7 an inverter assembly 10 is arranged. The inverter assembly 10 comprises a support structure, which is formed as a carrier plate 11. The carrier plate 11 is mounted on top of the struts 6 of the mounting dome 5.In addition, the inverter assembly 10 comprises a DC-link capacitor 12 and an AC-busbar 13, which are mounted on the carrier plate 11.

The carrier plate 11 is provided with an integrated cooling channel 14, through which a cooling fluid is circulated in order to from the inverter assembly 10. The cooling channel 14 contacts one side of power electronics 15, whereas the other side of the power electronics 15 is disposed on a printed circuit board (PCB) 16, on which other electronic devices are placed. The electric motor far and the inverter assembly 10 are assembled on separate production lines. The inverter assembly 10 is configured as a pre-assembled component. This pre-assembled module can subsequently be mounted in the inverter compartment 7 independently from the electric motor 4.

### List of reference numbers

- 1: electric motor assembly
- 2: motor housing
- 3: cavity
- 4: electric motor
- 5: mounting dome
- 6: struts
- 7: inverter compartment
- 8: wall
- 9: cover
- 10: inverter assembly
- 11: carrier plate
- 12: DC-link capacitor
- 13: AC-busbar
- 14: cooling channel
- 15: power electronics
- 16: printed circuit board (PCB)

## Claims

1. Inverter assembly (10) for an electric motor (4) or for a gearbox, said inverter assembly comprising a support structure, power electronics (15), a cooling channel (14), a DC-link capacitor (12) and a printed circuit board (PCB) (16), **characterized in that** the inverter assembly (10) is configured as a pre-assembled component, which is attachable respectively to the electric motor (4) or to the gearbox.

2. Inverter assembly according to claim 1, wherein the support structure is a carrier plate (11).

3. Inverter assembly according to claim 1 or 2, wherein the cooling channel (14) is integrated in the support structure.

4. Inverter assembly according to any one of claims 1 to 3, wherein one side of the power electronics (15) is disposed on the PCB (16) and the opposite side is attached to the cooling channel (14).

5. Inverter assembly according to any of the preceding claims, wherein it is configured without an inverter housing.

6. Inverter assembly according to any of the preceding claims, wherein the cooling channel (14) is connectable or connected to a cooling channel of the electric motor (4) or to a cooling channel of the gearbox.

7. Electric motor assembly (1), comprising:
- an electric motor (4),
- an inverter assembly (10) according to any one of claims 1 to 6,
- a motor housing (2) with a cavity (3) for the electric motor (4), wherein the motor housing (2) comprises a separate inverter compartment (7), in which the inverter assembly (10) is received.

8. Electric motor assembly according to claim 7, wherein the cavity (3) for the electric motor (4) and the inverter compartment (7) are separated by a wall (8) of the housing (2).

9. Electric motor assembly according to claim 7 or 8, wherein the inverter compartment (7) comprises a mounting dome (5) with struts (6), on which the inverter assembly (10) is arranged.

10. Electric motor according to any one of claims 7 to 9, wherein the inverter compartment (7) is provided with a cover (9), which closes an opening of the inverter compartment (7).

11. Gearbox assembly, comprising:
- a gearbox,
- an inverter assembly according to any one of claims 1 to 6,
- a housing with a cavity for the gearbox, wherein the housing comprises a separate inverter compartment, in which the inverter assembly is received.

12. Gearbox assembly according to claim 11, wherein the cavity for the gearbox and the inverter compartment are separated by a wall of the housing.

13. Gearbox assembly according to claim 11 or 12, wherein the inverter compartment comprises a mounting dome with struts, on which the inverter assembly is arranged.

14. Gearbox assembly according to any one of claims 11 to 13, wherein the inverter compartment is provided with a cover, which closes an opening of the inverter compartment.

15. Method for assembling an electric motor assembly (1) or a gearbox assembly, comprising the following steps:
- placing an electric motor (4) in a motor housing (2) or placing a gearbox in a gearbox housing;
- pre-assembling an inverter assembly (10) according to any one of claims 1 to 6, comprising a support structure, power electronics (15), a cooling channel (14), a DC-link capacitor (12) and a printed circuit board (PCB) (16); and
- arranging the inverter assembly (10) in a separate inverter compartment (7) of respectively the motor housing (2) or the gearbox housing.
